# EUROPEAN PATENT APPLICATION

(11) **EP 3 297 166 A1**
(43) Date of publication of application: **21.03.2018**
(21) Application number: 15891717.9
(22) Date of filing: 21.12.2015
(51) Int. Cl.: H03K 19/00

(54) **METHOD AND APPARATUS FOR ACHIEVING SWITCHING**

(30) Priority: 13.05.2015 CN 201510244151
(71) Applicant: ZTE Corporation, Shenzhen, Guangdong 518057 (CN)
(72) Inventor: WANG, Tao, Shenzhen Guangdong 518057 (CN)
(74) Representative: HGF Limited
(86) International application number: PCT/CN2015/098094
(87) International publication number: WO 2016/180024

(57) **Abstract**

A method and apparatus for implementing switching are provided. The apparatus includes: a control interface configured to, when a main power supply is not in place and power-off is required, output a first control signal to a switching control circuit; the switching control circuit configured to output a second control signal to a voltage regulation circuit according to the first control signal; and the voltage regulation circuit configured to control to execute a power-off operation according to the second control signal. By the solutions of the present invention, electronic equipment is prevented from entering power-off-power-on-power-off cycles.

## Description

### Technical Field

The present disclosure relates to the technical field of switching, and particularly to a method and apparatus for implementing switching.

### Background

In many kinds of electronic equipment, batteries are frequently required to continue providing safety protection as standby power supplies in case of unexpected power outage of main power supplies (which are usually alternating current power adapters), which is called as a endurance function. Due to an application characteristic, the electronic equipment is usually provided with no power switch buttons, starts working when being powered on with an Alternating Current (AC) voltage, and is automatically shut down when power of the battery is exhausted. For example, such electronic equipment is frequently used in the field of safety protection.

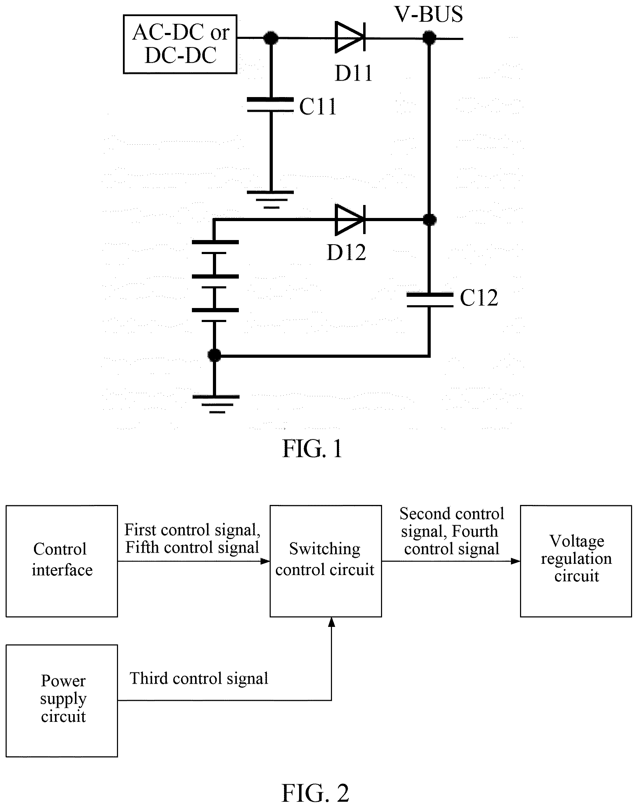

FIG. 1 is a schematic diagram of a switching circuit according to a related technology. As shown in FIG. 1, a Metal-Oxide-Semiconductor Field-Effect Transistor (MOSFET) or diode is connected in series with each of a main power branch circuit (AC-Direct Current (DC) or DC-DC) and a standby power branch circuit (i.e. a battery branch circuit). When an AC power adapter of the main power branch circuit is in place, the MOSFET or diode connected in series with the battery branch circuit is off; and when the AC power adapter is not in place, the MOSFET or diode of the battery branch circuit is conducting.

In a related switching circuit, when electronic equipment is automatically shut down at the end of endurance, an output voltage of a battery may be increased again to lead to a "electricity returning" phenomenon due to reduction of a load, and then the electronic equipment enters power-off-power-on-power-off cycles, and is namely repeatedly powered on, so that the electronic equipment is repeatedly started.

### Summary

The technical problem to be solved by the present invention is to provide a method and apparatus for implementing switching, to avoid electronic equipment being repeatedly started due to the fact that the electronic equipment is repeatedly powered on when the electronic equipment is automatically shut down at the end of endurance.

To achieve the abovementioned purpose, the following technical solutions are adopted.

An apparatus for implementing switching includes a control interface (BAT_OFF), a power supply circuit, a switching control circuit and a voltage regulation circuit.

The power supply circuit includes a battery branch circuit and an AC power adapter branch circuit, the switching control circuit includes a latch, and the voltage regulation circuit includes a voltage regulator.

Herein, the AC power adapter branch circuit includes a second P-channel Metal Oxide Semiconductor (PMOS) transistor (VT2), a first resistor (R1) and a fourth resistor (R4), and the battery branch circuit includes a first PMOS transistor (VT1), a second resistor (R2) and a third resistor (R3).

A drain of the first PMOS transistor (VT1) is connected with an output end (VBAT) of a battery and a first end of the third resistor (R3), a gate of the first PMOS transistor (VT1) is grounded through the second resistor (R2), and is connected with an output end of the AC power adapter and a first end of the fourth resistor (R4), a source of the first PMOS transistor (VT1) is connected with a source of the second PMOS transistor (VT2), and a second end of the third resistor (R3) is connected with the control interface (BAT_OFF) and a diode (VD1), and is connected with an S end of the latch through the diode (VD1).

A gate of the second PMOS transistor (VT2) is grounded through the first resistor (R1), a drain of the second PMOS transistor (VT2) is connected with the output end of the AC power adapter and the first end of the fourth resistor (R4), and a second end of the fourth resistor (R4) is connected with an R end of the latch.

Both the source of the first PMOS transistor (VT1) and the source of the second PMOS transistor (VT2) are connected with power input pins of the latch and the voltage regulator.

A PEN end of the latch is connected with an enable end (EN) of the voltage regulator.

In an exemplary embodiment, when only the battery is in place, the first PMOS transistor (VT1) is conducting, the second PMOS transistor (VT2) is off, and power is supplied through the battery branch circuit; and
when the AC power adapter is in place, the second PMOS transistor (VT2) is conducting, the first PMOS transistor (VT1) is off, power is supplied through the AC power adapter branch circuit, and no current is injected into the battery.

In an exemplary embodiment, when the battery is plugged, the third resistor (R3) and the diode (VD1) set the S end of the latch, and the PEN end of the latch is a low level;
after the AC power adapter is plugged, the fourth resistor (R4) sets the R end of the latch, and the PEN end of the latch is a high level;
after the battery is kept in place and the AC power adapter is removed, if the control interface (BAT_OFF) is reset, the latch latches output, and the PEN end of the latch continues keeping the high level, thereby implementing endurance; and if the control interface (BAT_OFF) is set, the latch flips, and the control interface (BAT_OFF) is turned into a low level to implement power-off.

In an exemplary embodiment, when the voltage regulator is a high level effective voltage regulator, the latch includes two NPN triodes and an N-channel Metal Oxide Semiconductor (NMOS) transistor, and the NMOS transistor is configured to negate an output signal of the latch; and
when the voltage regulator is a low level effective voltage regulator, the latch only includes the two NPN triodes.

In an exemplary embodiment, the voltage regulator is a Low Dropout Regulator (LDO) chip.

In an exemplary embodiment, a model number of the LDO chip is TPS73030 of the Texas Instruments (TI) company of USA.

In an exemplary embodiment, when the enable end (EN) of the voltage regulator is a high level, the LDO chip normally supplies power; and when the enable end (EN) of the voltage regulator is a low level, the LDO chip cuts off power.

A method for implementing switching, the method using any abovementioned apparatus for implementing switching, includes that:
when a system starts running a program, a high level is provided on the control interface (BAT_OFF); when there is only a battery, in case of accidental power-on, the level causes a switching circuit to power off the system, and thereafter, regardless of a state of the control interface (BAT_OFF), a switching apparatus keeps the system in an off state; and when the AC power adapter is in place, the high level of the control interface (BAT_OFF) cannot influence a power supply state of the switching apparatus.

In an exemplary embodiment, the method further includes that:
the control interface (BAT_OFF) keeps a low level after the high level; and
after the AC power adapter is removed, the control interface (BAT_OFF) is set to immediately power off the system, thereby causing the switching apparatus to keep the system in the off state regardless of the state of the control interface (BAT_OFF).

Compared with the related technology, the technical solution of the present invention includes: the control interface, configured to, when a main power supply is not place and power-off is required, output a first control signal to the switching control circuit; the switching control circuit, configured to output a second control signal to the voltage regulation circuit according to the first control signal; and the voltage regulation circuit, configured to control to execute a power-off operation according to the second control signal. By the solution of the present invention, electronic equipment is prevented from entering power-off-power-on-power-off cycles, thereby avoiding the electronic equipment being repeatedly started.

### Brief Description of Drawings

The drawings in embodiments of the present invention will be described below. The drawings in the embodiments are adopted to further understand the present invention, and to explain the present invention together with the specification and not intended to form limits to the scope of protection of the present invention.
FIG. 1 is a schematic diagram of a switching circuit according to the related technology.
FIG. 2 is a structure diagram of an apparatus for implementing switching according to an embodiment of the present invention.
FIG. 3 is a structure diagram of an apparatus for implementing switching according to a first embodiment of the present invention.
FIG. 4 is a structure diagram of an apparatus for implementing switching according to a second embodiment of the present invention.

### Detailed Description

Further descriptions about the present invention will be made below in combination with the drawings and not intended to limit the scope of protection of the present invention. It is important to note that the embodiments in the application and various approaches in the embodiments can be combined without conflicts.

Referring to FIG. 2, an embodiment of the present invention discloses an apparatus for implementing switching, which at least includes a control interface, a switching control circuit and a voltage regulation circuit.

The control interface is configured to, when a main power supply is not in place and power-off is required, output a first control signal to the switching control circuit.

Herein, the first control signal may be a high pulse or a high level.

The switching control circuit is configured to output a second control signal to the voltage regulation circuit according to the first control signal.

Herein, the second control signal may be a low level or a high level.

The voltage regulation circuit is configured to control to execute a power-off operation according to the second control signal.

Herein, the switching control circuit may be implemented by adopting a latch (for example, an RS latch).

Herein, the voltage regulation circuit may be implemented by adopting a voltage regulator with a switch.

The apparatus of an embodiment of the present invention further includes a power supply circuit.

The power supply circuit is configured to, when the main power supply is in place, output a third control signal to the switching control circuit through the main power supply. Correspondingly,
the switching control circuit is further configured to output a fourth control signal to the voltage regulation circuit according to the third control signal; and
the voltage regulation circuit is further configured to control to execute a power supply operation according to the fourth control signal.

Herein, the third control signal may be a high level, and the fourth control signal may be a high level or a low level.

Herein, the power supply circuit may be implemented by connecting MOSFETs in series with the main power supply and a standby power supply respectively.

The apparatus of an embodiment of the present invention further includes a power supply circuit.

The power supply circuit is configured to, when the main power supply is in place, output a third control signal to the switching control circuit through the main power supply.

The control interface is further configured to, when the main power supply is in place, output a fifth control signal to the switching control circuit. Correspondingly,
the switching control circuit is further configured to output a fourth control signal to the voltage regulation circuit according to the third control signal and the fifth control signal; and
the voltage regulation circuit is further configured to control to execute a power supply operation according to the fourth control signal.

Herein, the fifth control signal may be a low pulse or a low level.

In the apparatus of the embodiment of the present invention, the switching control circuit is further configured to, when the main power supply is not in place, keep outputting the fourth control signal to the voltage regulation circuit.

An embodiment of the present invention discloses a method for implementing switching, which includes that: when a main power supply is not in place and power-off is required, a control interface outputs a first control signal to a switching control circuit; the switching control circuit outputs a second control signal to a voltage regulation circuit according to the first control signal; and the voltage regulation circuit controls to execute a power-off operation according to the second control signal.

When the main power supply is in place, the method further includes that:
a power supply circuit outputs a third control signal to the switching control circuit through the main power supply; the switching control circuit outputs a fourth control signal to the voltage regulation circuit according to the third control signal; and the voltage regulation circuit controls to execute a power supply operation according to the fourth control signal.

Or, when the main power supply is in place, the method further includes that:
a power supply circuit outputs a third control signal to the switching control circuit through the main power supply; the control interface outputs a fifth control signal to the switching control circuit; the switching control circuit outputs a fourth control signal to the voltage regulation circuit according to the third control signal and the fifth control signal; and the voltage regulation circuit controls to execute a power supply operation according to the fourth control signal.

When the main power supply is not in place, before the voltage regulation circuit controls to execute the power supply operation according to the fourth control signal, the method further includes that:
the switching control circuit keeps outputting the fourth control signal to the voltage regulation circuit.

The apparatus of the embodiment of the present invention will be described below through specific embodiments in detail.

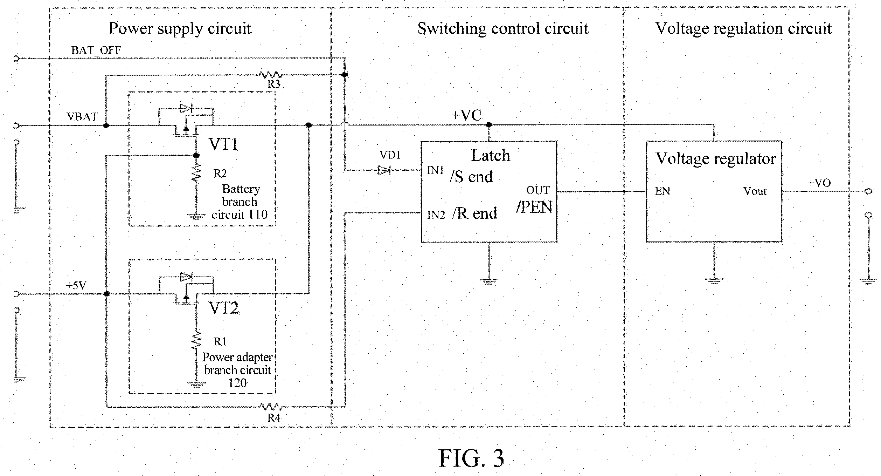

A first embodiment: referring to FIG. 3, the apparatus at least includes a power supply circuit 100, a switching control circuit 200 and a voltage regulation circuit 300.

The power supply circuit 100 includes a battery branch circuit 110 and an AC power adapter branch circuit 120. The switching control circuit 200 includes a latch. The voltage regulation circuit 300 includes a voltage regulator.

Herein, the battery branch circuit 110 includes a PMOS VT1, and the AC power adapter branch circuit 120 includes a PMOS VT2.

A gate of the PMOS VT1 is grounded through a resistor R2, and is connected with an output end (for example, +5V) of the AC power adapter and a first end of R4. A drain of the PMOS VT1 is connected with an output end VBAT of a battery (a cathode of the battery) and a first end of a resistor R3. A source of the PMOS VT1 is connected with a source of the PMOS VT2, and a second end of the resistor R3 is connected with a control interface BAT_OFF and a diode VD1, and is connected with an S end of the latch through the diode.

A gate of the PMOS VT2 is grounded through a resistor R1. A drain of the PMOS VT2 is connected with the output end (for example, +5V) of the AC power adapter and the first end of R4. And a second end of R4 is connected with an R end of the latch.

Both the source of the PMOS VT1 and the source of the PMOS VT2 are connected with power input pins of the latch and the voltage regulator.

An output end OUT, i.e. a PEN end, of the latch is connected with an enable end EN of the voltage regulator.

When only the battery is in place, the PMOS VT1 is conducting, the PMOS VT2 is off, and power is supplied through the battery branch circuit 110. When the AC power adapter is in place, the PMOS VT2 is conducting, the PMOS VT1 is off, power is supplied through the AC power adapter branch circuit 120, and no current is injected into the battery.

In the abovementioned circuit, the battery is connected with the S end of the latch through the resistor R3 and the ordinary PN junction diode VD1, and the control interface is connected with the S end of the latch through the ordinary PN junction diode VD1, and the AC power adapter is connected with the R end of the latch through the resistor R4.

When the battery is plugged, R3 and VD1 set the S end of the RS latch, and the PEN end of the latch is a low level.

After the AC power adapter is plugged, R4 sets the R end of the RS latch, and the PEN end of the RS latch is a high level; at this moment, for ensuring normal endurance, it is necessary to reset the control interface BAT_OFF.

After the battery is kept in place and the AC power adapter is removed, if BAT_OFF is reset, the RS latch latches output, and the PEN end continue keeping the high level to implement endurance; and if BAT_OFF is set (to be a high level), the latch flips, and PEN is turned into a low level to implement power-off.

In an exemplary embodiment, when the voltage regulator is a high level effective voltage regulator, the latch includes two NPN triodes and an NMOS transistor, and the NMOS transistor is configured to negate an output signal of the latch.

When the voltage regulator is a low level effective voltage regulator, the latch only includes the two NPN triodes.

In an exemplary embodiment, the voltage regulator is an LDO chip.

In an exemplary embodiment, a model number of the LDO chip is TPS73030 of the TI Company of USA.

In an exemplary embodiment, when an EN pin is a high level, the LDO chip normally supplies power; and when the EN pin is a low level, the LDO chip cuts off power.

A switching method of the embodiment of the present invention includes the following:
when a Micro Control Unit (MCU)/Central Processing Unit (CPU) of a system starts running a program, a high pulse is provided on BAT_OFF; and when there is only a battery, in case of accidental power-on, the pulse may cause a switching circuit to power off the system, and thereafter, regardless of a state of BAT_OFF, the switching circuit keeps the system in an off state.

When an AC power adapter is in place, the high pulse of BAT_OFF may not influence a power supply state of the switching circuit.

BAT_OFF keeps a low level after the high pulse. That the program may run till this moment indicates that the AC power adapter is in place and the system normally runs.

At a certain moment after the AC power adapter is removed, according to a requirement of a user or when a voltage of the battery at the end of endurance is low, BAT_OFF is set to immediately power off the system. Thereafter, the switching circuit keeps the system in the off state regardless of the state of BAT_OFF.

The switching method may run on the MCU/CPU of the system, as long as BAT_OFF is can be controlled regardless of a model number of the MCU/CPU.

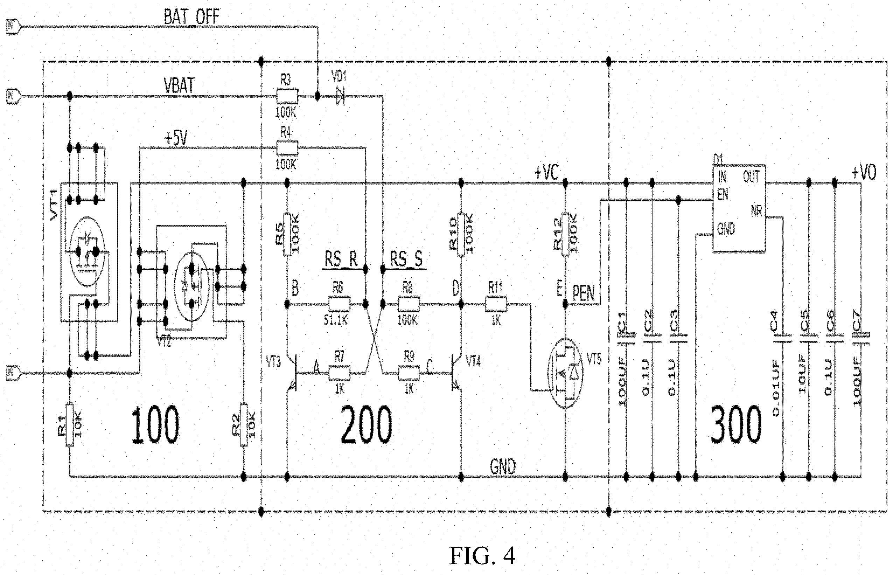

A second embodiment: referring to FIG. 4, the apparatus at least includes a power supply circuit, a switching control circuit and a voltage regulation circuit.

The power supply circuit includes a battery branch circuit 110 and an AC power adapter branch circuit 120. The battery branch circuit 110 includes a PMOS VT1, and the AC power adapter branch circuit 120 includes a PMOS VT2. A gate of the PMOS VT1 is grounded through a resistor R2, a drain of the PMOS VT1 is connected with a cathode of a battery, a source of the PMOS VT1 is connected with a source of the PMOS VT2, a gate of the PMOS VT2 is grounded through a resistor R1, and a drain of the PMOS VT2 is connected with an anode of an AC power adapter.

In FIG. 4, +5V represents output of the AC power adapter, and VBAT represents output of the battery.

The switching control circuit uses an RS latch. A control interface (i.e. BAT_OFF in the figure) is connected to an S end (i.e. an IN1 end, RS_S in the figure) of the RS latch through an ordinary PN junction diode VD1. The battery is connected to the S end of the RS latch through a resistor R3 and the ordinary PN junction diode VD1. The AC power adapter is connected to an R end (i.e. an IN1 end, RS_R in the figure) of the RS latch through a resistor R4. The S end in the RS latch is connected with an output end D through a resistor R8, the R end is connected with an output end B through a resistor R6. The source of the PMOS VT2 is connected with the output end B of the RS latch through a resistor R5, the output end B of the RS latch is grounded through an NPN triode VT3. The S end is connected with a base of the NPN triode VT3 through a resistor R7, the R end is connected with a base of an NPN triode VT4 through a resistor R9, and the output end D is grounded through the NPN triode VT4.

The voltage regulation circuit includes a Low Dropout Regulator (LDO) chip of which a model number is TPS73030 of the TI Company of USA. The output end D of the RS latch is connected with an enable end EN of the LDO through an NMOS VT5. The output end D of the RS latch is connected with a gate of the NMOS VT5 through a resistor R11, a source of the PMOS VT1 is connected with a drain of the NMOS VT5 through a resistor R12, a source of the NMOS VT5 is grounded, the drain of the NMOS VT5 is connected with the enable end EN of the LDO, and an output end OUT of the LDO is grounded through a capacitor C5.

A working principle of the apparatus is as follows.

When the AC power adapter is in place, the PMOS VT2 is conducting, the PMOS VT1 is off, the R end of the RS latch is set through the resistor R4 (that is, the power supply circuit sends a third control signal to the switching control circuit through a main power supply), output PEN is a high level (i.e. a fourth control signal), an input end of the LDO is also a high level (i.e. the fourth control signal), and then the LDO supplies power to electronic equipment.

When the AC power adapter is in place, if BAT_OFF is reset (that is, the control interface outputs a fifth control signal to the switching control circuit), when the AC power adapter is not in place and the battery is in place, the PMOS VT1 is conducting, the PMOS VT2 is off, the ordinary PN junction diode VD1 is in a reverse bias state, the latch is in a latch state, the output PEN keeps the high level (i.e. the fourth control signal), the input end of the LDO is also the high level (i.e. the fourth control signal), and the LDO supplies power to the electronic equipment.

If BAT_OFF is set (that is, the control interface outputs a first control signal to the switching control circuit), when the AC power adapter is not in place and the battery is in place, the S end is set through the ordinary PN junction diode VD1, the RS latch flips, the output PEN is a low level (i.e. a second control signal), the input end of the LDO is also a low level (i.e. the second control signal), and the LDO powers off the electronic equipment.

Herein, the second control signal and the fourth control signal may also be signals input into EN end of the LDO by the drain of the NMOS VT5.

That is, when the main power supply is not in place, BAT_OFF may be set to implement power-off, and when the main power supply is in place, BAT_OFF may be reset to implement battery endurance.

An embodiment of the present invention further discloses a computer program, which includes a program instruction, and the program instruction being executed by a computer enables the computer to execute any abovementioned method for implementing switching.

An embodiment of the present invention further discloses a carrier carrying the computer program.

It is important to note that the abovementioned embodiments are intended to facilitate understanding of those skilled in the art and not to limit the scope of protection of the present invention. Any obvious replacements, improvements and the like made to the present invention by those skilled in the art without departing from the inventive concept of the present invention shall fall within the scope of protection of the present invention.

### Industrial Applicability

By the solutions of the present invention, electronic equipment is prevented from entering power-off-power-on-power-off cycles, thereby avoiding the electronic equipment being repeatedly started. Therefore, the present invention has very high industrial applicability.

## Claims

1. An apparatus for implementing switching, comprising a control interface (BAT_OFF), a power supply circuit, a switching control circuit and a voltage regulation circuit, wherein
the power supply circuit comprises a battery branch circuit and an Alternating Current, AC, power adapter branch circuit, the switching control circuit comprises a latch, and the voltage regulation circuit comprises a voltage regulator,
wherein the AC power adapter branch circuit comprises a second P-channel Metal Oxide Semiconductor, PMOS, transistor (VT2), a first resistor (R1) and a fourth resistor (R4); and the battery branch circuit comprises a first PMOS transistor (VT1), a second resistor (R2) and a third resistor (R3),
a drain of the first PMOS transistor (VT1) is connected with an output end (VBAT) of a battery and a first end of the third resistor (R3), a gate of the first PMOS transistor (VT1) is grounded through the second resistor (R2), and is connected with an output end of the AC power adapter and a first end of the fourth resistor (R4), a source of the first PMOS transistor (VT1) is connected with a source of the second PMOS transistor (VT2), and a second end of the third resistor (R3) is connected with the control interface (BAT_OFF) and a diode (VD1), and is connected with an S end of the latch through the diode (VD1);
a gate of the second PMOS transistor (VT2) is grounded through the first resistor (R1), a drain of the second PMOS transistor (VT2) is connected with the output end of the AC power adapter and the first end of the fourth resistor (R4), and a second end of the fourth resistor (R4) is connected with an R end of the latch;
both the source of the first PMOS transistor (VT1) and the source of the second PMOS transistor (VT2) are connected with power input pins of the latch and the voltage regulator; and
a PEN end of the latch is connected with an enable end (EN) of the voltage regulator.

2. The apparatus for implementing switching according to claim 1, wherein,
when only the battery is in place, the first PMOS transistor (VT1) is conducting, the second PMOS transistor (VT2) is off, and power is supplied through the battery branch circuit; and
when the AC power adapter is in place, the second PMOS transistor (VT2) is conducting, the first PMOS transistor (VT1) is off, power is supplied through the AC power adapter branch circuit, and no current is injected into the battery.

3. The apparatus for implementing switching according to claim 1 or 2, wherein,
when the battery is plugged, the third resistor (R3) and the diode (VD1) set the S end of the latch, and the PEN end of the latch is a low level;
after the AC power adapter is plugged, the fourth resistor (R4) sets the R end of the latch, and the PEN end of the latch is a high level;
after the battery is kept in place and the AC power adapter is removed, if the control interface (BAT_OFF) is reset, the latch latches output, and the PEN end of the latch continues keeping the high level, thereby implementing endurance; and if the control interface (BAT_OFF) is set, the latch flips, and the control interface (BAT_OFF) is turned into a low level to implement power-off.

4. The apparatus for implementing switching according to claim 1 or 2, wherein,
when the voltage regulator is a high level effective voltage regulator, the latch comprises two NPN triodes and an N-channel Metal Oxide Semiconductor, NMOS, transistor, and the NMOS transistor is configured to negate an output signal of the latch; and
when the voltage regulator is a low level effective voltage regulator, the latch only comprises the two NPN triodes.

5. The apparatus for implementing switching according to claim 1 or 2, wherein
the voltage regulator is a Low Dropout Regulator, LDO, chip.

6. The apparatus for implementing switching according to claim 5, wherein
a model number of the LDO chip is TPS73030 of the Texas Instruments, TI, Company of USA.

7. The apparatus for implementing switching according to claim 5, wherein,
when the enable end (EN) of the voltage regulator is a high level, the LDO chip normally supplies power; and
when the enable end (EN) of the voltage regulator is a low level, the LDO chip cuts off power.

8. A method for implementing switching, the method using the apparatus for implementing switching according to any one of claims 1-7, comprising:
when a system starts running a program, providing a high level on the control interface (BAT_OFF); when there is only a battery, in case of accidental power-on, the level causing a switching circuit to power off the system, and thereafter, regardless of a state of the control interface (BAT_OFF), a switching apparatus keeping the system in an off state; when the Alternating Current, AC, power adapter is in place, the high level of the control interface (BAT_OFF) cannot influence a power supply state of the switching apparatus.

9. The method for implementing switching according to claim 8, the method further comprising:
keeping the control interface (BAT_OFF) a low level after the high level; and
after the AC power adapter is removed, setting the control interface (BAT_OFF) to immediately power off the system, causing the switching apparatus to keep the system in the off state regardless of the state of the control interface (BAT_OFF).
